# EUROPEAN PATENT APPLICATION

(11) **EP 4 620 990 A1**
(43) Date of publication of application: **24.09.2025**
(21) Application number: 23891733.0
(22) Date of filing: 12.06.2023
(51) Int. Cl.: C08F 222/10, C08F 230/08, C08F 220/18, C08F 220/28, C08F 2/50, H10K 50/842, H05B 33/04

(54) **COMPOSITION FOR ORGANIC LIGHT-EMITTING ELEMENT ENCAPSULATION AND ORGANIC LIGHT-EMITTING DISPLAY DEVICE COMPRISING SAME**

(30) Priority: 15.11.2022 KR 20220152825
(71) Applicant: Solus Advanced Materials Co., Ltd., Iksan-si, Jeollabuk-do 54588 (KR)
(72) Inventor: NOH, Seungjoo, Yongin-si Gyeonggi-do 16858 (KR); KONG, Yisung, Yongin-si Gyeonggi-do 16858 (KR); KIM, Choonghahn, Yongin-si Gyeonggi-do 16858 (KR)
(74) Representative: Office Freylinger
(86) International application number: PCT/KR2023/007988
(87) International publication number: WO 2024/106657

(57) **Abstract**

There is disclosed a composition for organic light emitting device encapsulation that has low dielectric constant characteristics of effectively blocking moisture or oxygen flowing into an organic light emitting display device from the outside, thereby ensuring the performance and lifespan of the organic light emitting device, and also improving touch sensitivity of a touch panel, and the organic light emitting display device including the same.

## Description

### [BACKGROUND]

### [Technical Field]

Embodiments of the present disclosure relate to a composition for organic light emitting device encapsulation and an organic light emitting display device including the same, more particularly, a composition for organic light emitting device encapsulation that has low dielectric constant characteristics of effectively blocking moisture or oxygen flowing into an organic light emitting display device from the outside, thereby ensuring the performance and lifespan of the organic light emitting device, and also improving touch sensitivity of a touch panel, and the organic light emitting display device including the same.

### [Background of the Disclosure]

Organic layer materials, electrodes, etc. that make up an organic light emitting device have a problem of their light emitting characteristics and lifespan are deteriorated by external moisture or oxygen. Accordingly, a protective layer configured to protect organic materials and electrodes, etc. is required. This protective layer is usually formed in a multi-layer structure of one or more organic and inorganic layers to effectively block external moisture or oxygen.

Recently, many capacitive touch panels using organic light emitting diodes are being adopted. Such a capacitive touch panel is configured to touch by a change in capacitance when a conductor comes into contact with a touch panel. In case of high-dielectric constant materials, when an external electric field is applied, polarization tends to occur, which reduces touch sensitivity. Accordingly, there is a demand for the development of a composition for encapsulating an organic layer used in the multi-layer structure having low-dielectric constant characteristics and excellent touch sensitivity of a touch panel.

### [DETAILED DESCRIPTION OF THE INVENTION]

### [Technical Problem]

Accordingly, one object of the present disclosure is to solve the above-noted disadvantages of the prior art, and to provide a composition for encapsulation of an organic light emitting device that has low dielectric constant characteristics of effectively blocking moisture or oxygen flowing into an organic light emitting display device from the outside, thereby ensuring the performance and lifespan of the organic light emitting device, and also improving touch sensitivity of a touch panel, and the organic light emitting display device including the same.

### [Technical Solution]

To solve the objects of the present disclosure, a composition for organic light emitting encapsulation may include a photocurable monomer including all (meth)acrylate monomers represented by the following chemical formulas 1, 2, 3, and 4; and a photopolymerization initiator, and a dielectric constant may be 2.65 or less at a frequency in a range of 100 khz to 1MHz,

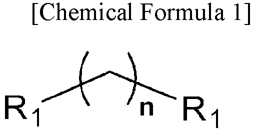

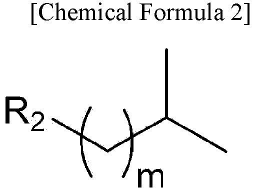

[Chemical Formula 3] R₃-L₁-R₄,

and

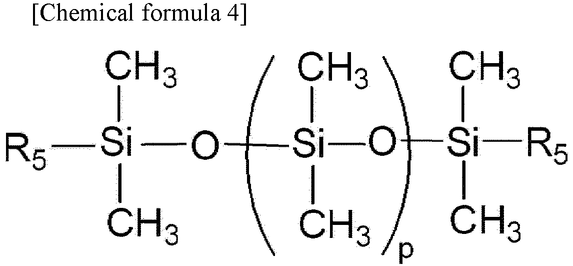

In the chemical formulas 1 to 4, R₁ to R₃ may be each independently a (meth)acryloyl group, R₄ may be a substituted or unsubstituted C₆-₁₂ bridged cycloalkyl group, R₅ may be a vinyl group or (meth)acryloyl group, L₁ may be independently a single bond or alkylene group, n may be 14 to 18, m is 5 to 15, and p is 0 to 10.

The composition for the organic light emitting device may have a viscosity of 10 to 30 cPs.

The photocurable monomer may be contained in an amount of 20 to 99 wt% based on the total weight of the composition.

The (meth)acrylate monomer represented by the chemical formula 1 may include one or more selected from the group consisting of 1,14-tetradecanediol di(meth)acrylate, 1,15-pentadecanediol di(meth)acrylate, 1,16-hexadecanediol di(meth)acrylate, 1,17-heptadecanediol di(meth)acrylate, and 1,18-octadecanediol di(meth)acrylate.

The (meth)acylate monomer represented by the chemical formula 2 may include one or more selected from the group consisting of isotetradecyl (meth)acrylate, isopentadecyl (meth)acrylate, isohexadecyl (meth)acrylate, isoheptadecyl (meth)acrylate, and isooctadecyl (meth)acrylate.

The (meth)acrylate monomer represented by the chemical formula 3 may include one or more selected from the group consisting of isobornyl (meth)acrylate, norbornylmethyl (meth)acrylate, 3-methyl-2-norbornylmethyl (meth)acrylate, dicyclopentenyl (meth)acrylate, dicyclopentenyloxyethyl (meth)acrylate, dicyclopentanyl (meth)acrylate, tricyclodecanyl (meth)acrylate and adamantyl (meth)acrylate.

The monomer represented by the chemical formula 4 may be a monomer represented by the following chemical formula 5 or chemical formula 6.

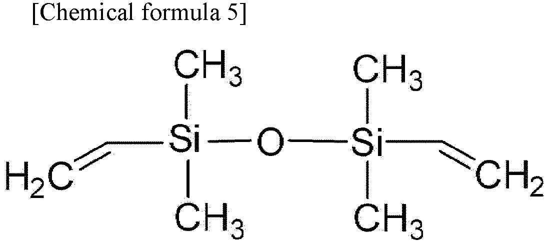

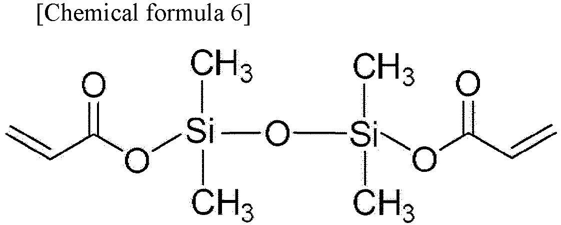

The photopolymerization initiator includes one or more selected from triazine-based, acetophenone-based, benzophenone-based, thioxanthone-based, benzoin-based, phosphorus-based, oxime-based, and a mixture thereof.

The composition for the organic light emitting encapsulation of claim 1, wherein the photopolymerization initiator is included in an amount of 0.1 to 10 wt% based on the total weight of the composition

The composition for the organic light emitting encapsulation may further include an additive including one or more selected from the group consisting of a surfactant, a curing accelerator, and an antioxidant.

An organic light emitting display device according to another embodiment of the present disclosure may include an encapsulation part containing the composition.

### [Advantageous Effects]

When the encapsulation part of the organic light emitting display device is formed by using the composition for the encapsulation of the organic light emitting device according to the embodiments of the present disclosure, moisture or oxygen flowing from the outside can be effectively blocked, thereby ensuring the performance and lifespan, and also the low-dielectric constant characteristics may be given, thereby having an effect of excellent touch sensitivity of a touch panel.

### [Description of Drawings]

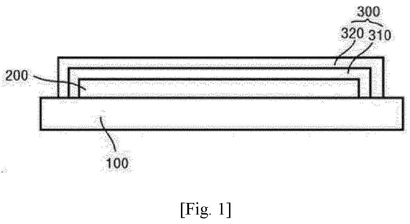

FIG. 1 is a diagram of an organic light emitting display device according to an embodiment of the present disclosure.

### [DESCRIPTION OF SPECIFIC EMBODIMENTS]

Referring to the accompanying drawings, embodiments of the present disclosure will be described in detail.

Description will now be given in detail according to exemplary embodiments disclosed herein, with reference to the accompanying drawings. For the sake of brief description with reference to the drawings, the same or equivalent components may be provided with the same reference numbers, and description thereof will not be repeated.

It will be understood that when an element is referred to as being "connected with", "on" or "coupled to" another element, the element can be directly connected with the other element or intervening elements may also be "connected with" or "coupled to". It will be also understood that when an element such as a layer, film, area, plate, etc. is "on" or "above", the element may be "directly on" or "directly above" another element and also intervening elements may be present between them. In contrast, when an element is referred to as being "directly on" another element, there are no intervening elements present. Terminologies such as "under", "below", "on", "above", and etc. are used to describe location relationship between the elements shown in the drawings. Such terminologies are relative concepts and described with respect to directions shown in the accompanying drawings. Unless "immediately" or "directly" is used when describing location relationship, for example, "on", "above", "under", "next", etc., one or more other elements such as layers, films, areas, plates, etc. may be also present.

The term of "(meth)acryl" as used herein means acryl and/or methacryl.

The term of "alkyl group" used herein, unless otherwise stated, means a radical of a saturated aliphatic functional group having 1 to 60 carbon atoms connected by a single bond, including a straight-chain alkyl group, a branched-chain alkyl group, a cycloalkyl (alicyclic) group, an alkyl-substituted cycloalkyl group, and a cycloalkyl-substituted alkyl group.

The term of "alkylene group" used herein means an alkanediyl group linked to a saturated hydrocarbon without a double bond, and means having two linking groups.

Also, unless explicitly stated otherwise, the term of "substituted or unsubstituted" used herein means that the "substituted" may be substituted with one or more substituents selected from the group consisting of deuterium, halogen, an amino group, a nitrile group, a nitro group, a C₁₋₂₀ alkyl group, a C₁₋₂₀ alkoxy group, a C₁₋₂₀ alkylamine group, a C₁₋₂₀ alkylthiophene group, a C₆₋₂₀ arylthiophene group, a C₂₋₂₀ alkenyl group, a C₂₋₂₀ alkynyl group, a C₃₋₂₀ cycloalkyl group, a C₆₋₂₀ aryl group, a C₆₋₂₀ aryl group substituted with deuterium, a C₈₋₂₀ arylalkenyl group, a silane group, a boron group, and a C₂₋₂₀ heterocyclic group containing at least one heteroatom selected from the group consisting of O, N, S, Si, and P, but is not necessarily substituted with these substituents. However, embodiments are not limited to substituents.

The term of "dielectric constant" used herein means a value measured by the capacitance method for an organic layer including the composition for encapsulating an organic light emitting device according to the present disclosure.

The term of "viscosity" used in the present disclosure means a value measured using a rotational viscometer for an organic layer including a composition for encapsulating an organic light emitting device according to the present disclosure.

The composition for encapsulating an organic light emitting device according to the present disclosure may include a photocurable monomer and a photopolymerization initiator including all of the (meth)acrylates represented by the following chemical formulas 1, 2, and 3, and may have a characteristic of a dielectric constant of 2.65 or less at a frequency in the range of 100 kHz to 1MHz. the viscosity of the composition mya be 10 to 30 cPs.

The photocurable monomer may include a photocurable monomer including all (meth)acrylates represented by the following chemical formulas 1 to 4; and a photopolymerization initiator;

Composition for organic light emitting device encapsulation having a dielectric constant of 2.65 or less at a frequency in the range of 100 kHz to 1MHz:

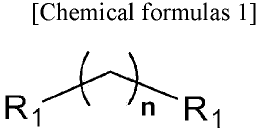

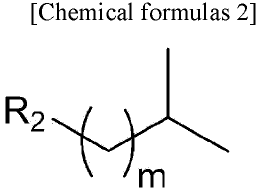

[Chemical formulas 3] R₃-L₁-R₄

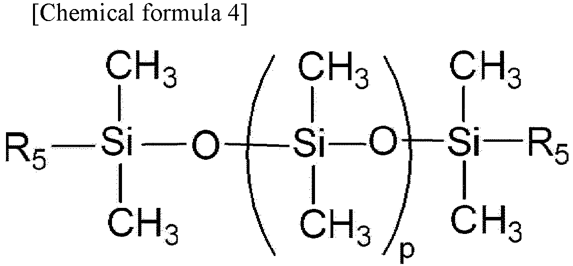

In the chemical formulas 1 to 4, R₁ to R₃ are each independently a (meth)acryloyl group, R4 is a substituted or unsubstituted C₆₋₁₂ bridged cycloalkyl group, and R₅ may be a vinyl group or (meth)acryloyl group, L₁ may be independently a single bond or alkylene group, n may be 14 to 18, m is 5 to 15, and p is 0 to 10

It is preferred that the photocurable monomer is included in an amount of 20 to 99 wt% based on the total weight of the composition.

More specifically, the (meth)acrylate monomer represented by the above chemical formula 1 may include one or more selected from the group consisting of 1,14-tetradecanediol di(meth)acrylate, 1,15-pentadecanediol di(meth)acrylate, 1,16-hexadecanediol di(meth)acrylate, 1,17-heptadecanediol di(meth)acrylate, and 1,18-octadecanediol di(meth)acrylate, but the embodiment of the present disclosure is not necessarily limited thereto.

In addition, the (meth)acylate monomer represented by the above chemical formula 2 may include one or more selected from the group consisting of isotetradecyl (meth)acrylate, isopentadecyl (meth)acrylate, isohexadecyl (meth)acrylate, isoheptadecyl (meth)acrylate, and isooctadecyl (meth)acrylate, but the embodiment of the present disclosure is not necessarily limited thereto.

The (meth)acrylate monomer represented by the above chemical formula 3 may include one or more selected from the group consisting of isobornyl (meth)acrylate, norbornylmethyl (meth)acrylate, 3-methyl-2-norbornylmethyl (meth)acrylate, dicyclopentenyl (meth)acrylate, dicyclopentenyloxyethyl (meth)acrylate, dicyclopentanyl (meth)acrylate, tricyclodecanyl (meth)acrylate, and adamantyl (meth)acrylate, but the embodiment of the present disclosure is not necessarily limited thereto.

The monomer represented by the chemical formula 4 may be a monomer represented by the following chemical formula 5 or chemical formula 6, but the embodiment of the present disclosure is not necessarily limited thereto.

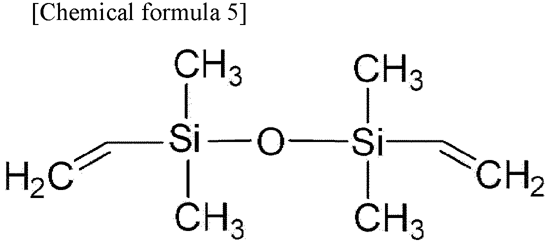

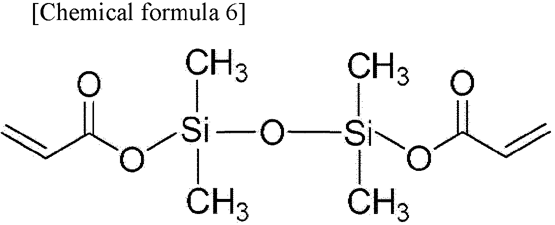

The composition for organic light emitting device encapsulation may include a photopolymerization initiator configured to curing the photocurable monomer through UV irradiation or the like. The photopolymerization initiator is not particularly limited as long as it is a conventional photopolymerization initiator capable of performing a photocurable reaction. For example, the photopolymerization initiator may include triazine-based, acetophenone-based, benzophenone-based, thioxanthone-based, benzoin-based, phosphorus-based, oxime-based, or a mixture thereof.

The triazine-based material may be 2,4,6-trichloro-s-triazine, 2-phenyl-4,6-bis(trichloromethyl)-s-triazine, 2-(3',4'-dimethoxy styryl)-4,6-bis(trichloromethyl)-s-triazine, 2-(4'-methoxy naphthyl)-4,6-bis(trichloromethyl)-s-triazine, 2-(p-methoxy phenyl)-4,6-bis(trichloromethyl)-s-triazine, 2-(p-tolyl)-4,6-bis(trichloromethyl)-s-triazine, 2-biphenyl-4,6-bis(trichloromethyl)-s-triazine, bis(trichloromethyl)-6-styryl-s-triazine, 2-(naphtho-1-yl)-4,6-bis(trichloromethyl)-s-triazine, 2-(4-methoxy naphtho-1-yl)-4,6-bis(trichloromethyl)-s-triazine, 2,4-trichloromethyl(piperonyl)-6-triazine, 2,4-(trichloromethyl(4'-methoxy styryl)-6-triazine or a mixture thereof.

The acetophenone-based material may be 2,2'-diethoxy acetophenone, 2,2'-dibutoxy acetophenone, 2- hydroxy-2-methyl propiophenone, pt-butyl trichloro acetophenone, p-t-butyl dichloro acetophenone, 4-chloro acetophenone, 2,2'-dichloro-4-phenoxy acetophenone, 2-methyl-1-(4-(methylthio)phenyl)-2-morpholino propan-1-one, 2-benzyl-2-dimethyl amino-1-(4-morpholino phenyl)-butan-1-one, or a mixture thereof.

The benzophenone-based material may be benzophenone, benzoyl benzoate, methyl benzoyl benzoate, 4-phenyl benzophenone, hydroxy benzophenone, acrylated benzophenone, 4,4'-bis(dimethylamino)benzophenone, 4,4'-dichloro benzophenone, 3,3'-dimethyl-2-methoxy benzophenone, or a mixture thereof.

The thioxanthone-based material may be thioxanthone, 2-methyl thioxanthone, isopropyl thioxanthone, 2,4-diethyl thioxanthone, 2,4-diisopropyl thioxanthone, 2-chloro thioxanthone, or a mixture thereof.

The benzoin-based material may be benzoin, benzoin methyl ether, benzoin ethyl ether, benzoin isopropyl ether, benzoin isobutyl ether, benzyl dimethyl ketal or a mixture thereof.

The phosphorus-based material may be bisbenzoylphenyl phosphine oxide, benzoyldiphenyl phosphine oxide or a mixture thereof.

The oxime-based material may be 2-(o-benzoyloxime)-1-[4-(phenylthio)phenyl]-1,2-octanedione and 1-(o-acetyloxime)-1-[9-ethyl-6-(2-methylbenzoyl)-9H-carbazol-3-yl]ethanone, or a mixture thereof.

It is preferred that the photopolymerization initiator is included in an amount of 0.1 to 10 wt% based on the total weight of the composition. This is because when the photopolymerization initiator is included in the above content range, not only can photopolymerization sufficiently occur upon exposure, but also outgassing and reliability deterioration due to unreacted initiator remaining after photopolymerization can be prevented.

The composition for organic light emitting device encapsulation according to the present disclosure may further include at least one additive including one or more selected from the group consisting of a surfactant, a curing accelerator, and an antioxidant. In particular, the surfactant is advantageous in inducing dispersion of the composition.

The composition for organic light emitting device encapsulation according to the present disclosure may have the characteristic of a low dielectric constant of 2.65 or less at a frequency of 100kHz to 1MHz. accordingly, when the composition for encapsulation is applied to a touch panel, it has an excellent effect of improving touch sensitivity.

In addition, it is preferred that the composition for the organic light emitting device encapsulation according to the present disclosure may have the viscosity of 10 to 30 cPs, because the processability of the composition may be further improved within the above viscosity range.

An organic light emitting display device that is another invention according to the present disclosure may include an encapsulation part containing the composition for the organic light emitting device encapsulation.

FIG. 1 is a diagram of an organic light emitting display device according to an embodiment of the present disclosure. The organic light emitting device shown in FIG. 1 may include a substrate 100, an organic light emitting device 200 disposed on the substrate 100, and an encapsulation part 300 disposed on the organic light emitting device 200. At this time, the encapsulation part 200 may be shown as a multi-layer structure composed of a first encapsulation layer 310 and a second encapsulation layer 320, but the present disclosure proposes that the encapsulation part 300 may include the configuration in which the encapsulation part 300 has two layers and the configuration in which it has four or more layers. When the encapsulation part 300 is configured of the multi-layer structure including two layers, an inorganic barrier layer and an organic barrier layer. For example, when the first encapsulation layer 310 is an organic barrier layer, the second encapsulation layer 320 may be an organic barrier layer, but the order of the multi-layers is not limited thereto.

The encapsulation part 300 may form an organic barrier layer for the purpose of encapsulating the organic light emitting display device, and the organic barrier layer may be formed by photocuring the composition for the organic light emitting device encapsulation according to the present disclosure.

The composition for encapsulation (organic barrier layer material) may be applied by inkjet, vacuum deposition, spin coating or slit coating methods, and an initiator may be used during the photocuring.

Hereinafter, the present disclosure will be specifically described by way of embodiments of the composition for the organic light emitting device encapsulation according to the embodiment, but the present disclosure is not limited to the following embodiments.

### [Embodiments]

The photocurable monomer and the photoinitiator BAPO below were mixed in a weight ratio described in Table 1 to prepare Examples 1 to 4 and Comparative Examples 1 to 5 of the composition for organic light emitting encapsulation.

After that, the compositions prepared as described above was stirred for 12 hours and filtered through a PTFE filter with a pore size of 0.45 µm.

The filtered composition for the organic light emitting device encapsulation was formed with a thickness of 8.0 µm or more by spin coating, and then a UV exposure device was used to irradiate the composition with a light amount of 1 J to form an encapsulation film. The dielectric constant and viscosity were measured using the flowing methods.

Permittivity: the composition for organic light emitting device encapsulation was coated and cured on a lower electrode to a thickness of 8.0 µm or more. After that, an upper electrode Ag was deposited to a thickness of 1,000 Å. The dielectric constant of the manufactured specimen was measured using KEYSIGHT, E4980A, and then calculated.

Viscosity: the viscosity of the composition for liquid organic light emitting device encapsulation was measured using a rotational viscometer.

As a result, the dielectric constants of the encapsulation films formed with the compositions for organic light emitting device encapsulation in Examples 1 and 4 according to the present disclosure were all 2.65 F/m or less, but the dielectric constants of the encapsulation films formed in Comparative Examples 1 to 5 exceeded 2.65 F/m. Accordingly, it was confirmed that a touch panel to which the encapsulation film manufactured according to the present disclosure is applied may obtain an effect of superior touch sensitivity.

**[Table 1]**

| No. | | Phtocurable monomer | | | | | Photoinitiat or (BAPO) | Dielectric constant | Viscocity | Surface Tension | Permeabil ity |
|---|---|---|---|---|---|---|---|---|---|---|---|
| | | DVSO | DMASO | TDMA | IBOMA | ISTA | | [F/m] | [cPs] | [mN/m] | [%] |
| Example | 1 | 20 | | 10 | 35 | 35 | 2 | 2.56 | 11.5 | 28.5 | 99.5 |
| | 2 | 45 | | | 20 | 35 | 2 | 2.55 | 11.2 | 26.3 | 99.5 |
| | 3 | | 20 | 10 | 35 | 35 | 2 | 2.59 | 11.4 | 28.7 | 99.5 |
| | 4 | | 45 | | 20 | 35 | 2 | 2.58 | 11.1 | 26.5 | 99.5 |
| Comparati ve Example | 1 | | | 30 | 35 | 35 | 2 | 2.85 | 13.2 | 31.1 | 99.5 |
| | 2 | | | 20 | 30 | 30 | 2 | 2.82 | 13.1 | 31.0 | 99.5 |
| | 3 | | | 10 | 25 | 25 | 2 | 2.79 | 13.3 | 31.0 | 99.5 |
| | 4 | | | 30 | 45 | 25 | 2 | 2.95 | 13.2 | 31.1 | 99.5 |
| | *5* | | | 30 | 25 | 45 | 2 | 2.84 | 13.2 | 31.1 | 99.5 |

| | | | | | | | | | | | |
|---|---|---|---|---|---|---|---|---|---|---|---|
| DVSO : 1,3-Divinyltetramethyldisiloxane (CAS : 2627-95-4) DMASO : 1,3-bis(3-methacryloxypropyl)tetramethyldisiloxane (CAS : 18547-93-8) TDMA : 1,14-Tetradecanediol dimethacrylate (CAS : 168473-14-1) IBOMA : Isobornyl Acrylate (CAS : 5888-33-5) ISTA : Isooctadecyl acrylate (CAS : 93841-48-6) BAPO : Bis(2,4,6-trimethylbenzoyl)-phenylphosphineoxide (CAS : 162881-26-7 | | | | | | | | | | | |

Although the present invention has been described with reference to the exemplified drawings, it is to be understood that the present invention is not limited to the embodiments and drawings disclosed in this specification, and those skilled in the art will appreciate that various modifications are possible without departing from the scope and spirit of the present invention. Further, although the operating effects according to the configuration of the present invention are not explicitly described while describing an embodiment of the present invention, it should be appreciated that predictable effects are also to be recognized by the configuration.

### [Description of Numeral References]

100: Substrate
200: Organic light emitting device
300: Encapsulation part
310: First encapsulation part
320: Second encapsulation part

## Claims

1. A composition for organic light emitting encapsulation comprising:
a photocurable monomer including all (meth)acrylate monomers represented by the following chemical formulas 1, 2, 3, and 4; and
a photopolymerization initiator,
wherein a dielectric constant is 2.65 or less at a frequency in a range of 100 khz to 1MHz, 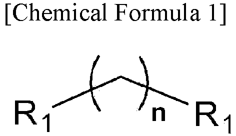 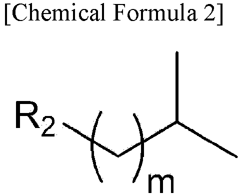
[Chemical Formula 3] R₃-L₁-R₄, 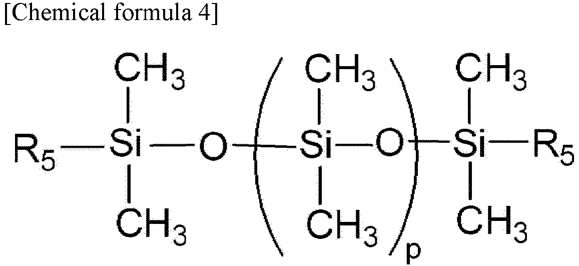
in the chemical formulas 1 to 4,
R₁ to R₃ are each independently a (meth)acryloyl group,
R₄ is a substituted or unsubstituted C6-12 bridged cycloalkyl group,
R₅ is a vinyl group or (meth)acryloyl group,
L₁ is independently a single bond or alkylene group,
n is 14 to 18,
m is 5 to 15, and
p is 0 to 10.

2. The composition for the organic light emitting encapsulation of claim 1, wherein the composition for the organic light emitting device has a viscosity of 10 to 30 cPs.

3. The composition for the organic light emitting encapsulation of claim 1, wherein the photocurable monomer is contained in an amount of 20 to 99 wt% based on the total weight of the composition.

4. The composition for the organic light emitting encapsulation of claim 1, wherein the (meth)acrylate monomer represented by the chemical formula 1 includes one or more selected from the group consisting of 1,14-tetradecanediol di(meth)acrylate, 1,15-pentadecanediol di(meth)acrylate, 1,16-hexadecanediol di(meth)acrylate, 1,17-heptadecanediol di(meth)acrylate, and 1,18-octadecanediol di(meth)acrylate.

5. The composition for the organic light emitting encapsulation of claim 1, wherein the (meth)acylate monomer represented by the chemical formula 2 includes one or more selected from the group consisting of isotetradecyl (meth)acrylate, isopentadecyl (meth)acrylate, isohexadecyl (meth)acrylate, isoheptadecyl (meth)acrylate, and isooctadecyl (meth)acrylate.

6. The composition for the organic light emitting encapsulation of claim 1, wherein the (meth)acrylate monomer represented by the chemical formula 3 includes one or more selected from the group consisting of isobornyl (meth)acrylate, norbornylmethyl (meth)acrylate, 3-methyl-2-norbornylmethyl (meth)acrylate, dicyclopentenyl (meth)acrylate, dicyclopentenyloxyethyl (meth)acrylate, dicyclopentanyl (meth)acrylate, tricyclodecanyl (meth)acrylate and adamantyl (meth)acrylate.

7. The composition for the organic light emitting encapsulation of claim 1, wherein the monomer represented by the chemical formula 4 may be a monomer represented by the following chemical formula 5 or chemical formula 6,

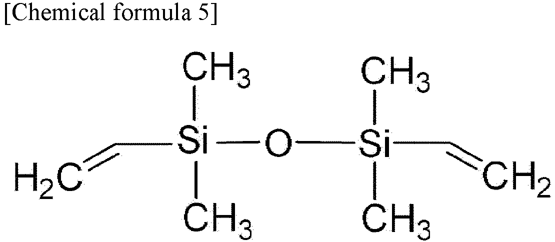

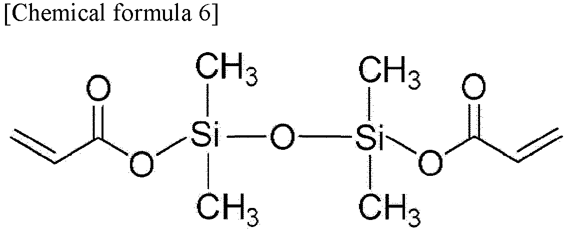

8. The composition for the organic light emitting encapsulation of claim 1, wherein the photopolymerization initiator includes one or more selected from triazine-based, acetophenone-based, benzophenone-based, thioxanthone-based, benzoin-based, phosphorus-based, oxime-based, and a mixture thereof.

9. The composition for the organic light emitting encapsulation of claim 1, wherein the photopolymerization initiator is included in an amount of 0.1 to 10 wt% based on the total weight of the composition

10. The composition for the organic light emitting encapsulation of claim 1, further comprising:
an additive including one or more selected from the group consisting of a surfactant, a curing accelerator, and an antioxidant.

11. An organic light emitting display device comprising:
the composition of one of claims 1 to 10.
